(19) Europäisches Patentamt
European Patent Office
Office européen des brevets

(11) EP 1 107 255 A2

(12) EUROPEAN PATENT APPLICATION

(43) Date of publication:
13.06.2001 Bulletin 2001/24

(51) Int Cl.$^7$: G11B 27/10, G11B 20/10,
G11B 19/12, G06F 17/60

(21) Application number: 00126418.3

(22) Date of filing: 05.12.2000

(84) Designated Contracting States:
AT BE CH CY DE DK ES FI FR GB GR IE IT LI LU
MC NL PT SE TR
Designated Extension States:
AL LT LV MK RO SI

(30) Priority: 06.12.1999 JP 34577699

(71) Applicant: MATSUSHITA ELECTRIC INDUSTRIAL
CO., LTD.
Kadoma-shi, Osaka 571-8501 (JP)

(72) Inventor: So, Hirokazu
Moriguchi-shi, Osaka-fu (JP)

(74) Representative: Lang, Johannes, Dipl.-Ing. et al
Bardehle Pagenberg Dost Altenburg Geissler
Isenbruck,
Postfach 86 06 20
81633 München (DE)

(54) Recording medium, data recording and reproducing device, and system for collecting reproduction control information

(57) A recording medium (100) having recorded digital data includes a content data storage region (10), a reproduction control information storage region (20) having a parameter for determining a reproduction frequency at random reproduction, and an index storage region (30). The reproduction control information in the reproduction control storage region (20) is updatable. Therefore, the reproduction control information helps the reproduction frequency to change at reproduction if utilized for determining the reproduction frequency in a data recording and reproducing device.

F I G. 1

**Description**

BACKGROUND OF THE INVENTION

Field of the Invention

The present invention relates to a recording medium on which digital data is recorded, and a data recording and reproducing device for reproducing the digital data. More specifically, the digital data recorded on the recording medium includes reproduction control information, and with the help thereof, the data recording and reproducing device randomly reproduces the digital data.

Description of the Background Art

A conventionally popular recording medium for storing digital data is an optical disk such as a laser disk (LD), compact disk (CD), mini disk (MD), and DVD. Recently, a smaller-sized semiconductor memory has started to take over such optical disk as is advantageously free from dropout.
As to such recording medium, data recorded thereon is generally reproduced in a sequential manner. In the case that the data is music, however, content data thereon, i.e., tracks, may be randomly changed in order when reproduced. This method is called random reproduction.
In such random reproduction, commonly utilized are random numbers to randomly determine the order of content data for reproduction. The random numbers are generated by a random number generator, which is often provided in a data recording and reproducing device where content data is reproduced. Thus generated random numbers are referred to for determining which content data is to be reproduced now.
Here, the random numbers outputted by such random number generator are generally in a predetermined value range, and almost equal in probability. Therefore, at random reproduction, each content data is reproduced with equal frequency by a data recording and reproducing device.
As a variation of random reproduction, shuffle reproduction is included. In shuffle reproduction, a plurality of content data recorded on a recording medium is randomly reproduced as in random reproduction. However, after reproduced on a one-time basis, the content data is stored on a reproducing device side, and thus is not reproduced twice. This method is disclosed in Japanese Utility Model Laid-Open Publication No. 60-146989 (85-146989).
Disclosed in Domestic Re-publication of PCT International Publication for Patent Applications No. 9-807509 (97-807509) is another type of shuffle reproduction method utilizing an optical disk. In this method, each content data is provided with a flag so as to unequalize the reproduction frequency thereof. The flag specifies the number of content data to be reproduced, and once the number indicated by a counter exceeds that on the flag, the content data is not allowed to be reproduced.
In such conventional methods, however, the reproduction frequency of content data is fixed once determined, and thus is not changeable. Therefore, at random reproduction, users' preferences for content data are hardly reflected in the reproduction frequency. Specifically, there is no concern for increasing the reproduction frequency of content data which has been currently recorded or reproduced so far many times.
In the case that data is reproduced not randomly but sequentially, the reproduction frequency is fixed from the beginning, whereby the users' preferences for content data are also hardly reflected in the reproduction frequency. These are the problems found in the conventional methods.

SUMMARY OF THE INVENTION

Therefore, an object of the present invention is to provide a recording medium and a data recording and reproducing device capable of changing the reproduction frequency or order of content data both at random and sequential reproduction. Another object of the present invention is to provide a system for collecting and making use of reproduction frequency information which is used on the recording medium and the data recording and reproducing device.
The present invention has the following features to attain the objects above.
A first aspect of the present invention is directed to a recording medium for storing digital data to be read/updated by a data recording and reproducing device,
     the digital data comprising:

     a plurality of content data reproducable by the data recording and reproducing device; and
     reproduction control information used to determine the content data to be reproduced, wherein

the reproduction control information includes reproduction sequence information which determines a reproduction order of the plurality of content data while the data recording and reproducing device performs normal reproduction, and reproduction frequency parameters each of which determines reproduction frequency of the content data while the data recording and reproducing device performs special reproduction, the reproduction frequency parameters being updatable.

As described above, in the first aspect, provided is a recording medium which can change a reproduction frequency or order of content data both at random and sequential reproduction according to a user's preferences.

According to a second aspect, in the first aspect,

the reproduction frequency parameters are updated according to information relevant to the content data selected at normal reproduction.

As described above, in the second aspect, the reproduction frequency parameters are updated based on information relevant to the content data selected at normal reproduction in the data recording and reproducing device, for example, when the content data was reproduced or how many times so far reproduced. Therefore, the reproduction frequency parameters can reflect the user's preferences.

According to a third aspect, in the first aspect,

the reproduction control information includes information about date and time when the content data is recorded.

As described above, in the third aspect, provided is a recording medium which can change the reproduction frequency or order of content data at reproduction based on information about date when the content data was recorded.

According to a fourth aspect, in the first aspect,

the reproduction control information includes information about date and time when the content data is reproduced last time.

As described above, in the fourth aspect, provided is a recording medium which can change the reproduction frequency or order of content data at reproduction based on information about date when the content data was reproduced last time.

According to a fifth aspect, in the first aspect,

the reproduction control information includes information about the number of times the content data has been reproduced.

As described above, in the fifth aspect, provided is a recording medium which can change the reproduction frequency or order of content data at reproduction based on information about the number of times the content data has been so far reproduced.

A sixth aspect of the present invention is directed to a data recording and reproducing device for reproducing digital data to be read/updated in the recording medium of claim 1, the device comprising:

a determination part operable to read the reproduction control information from the recording medium, and generate information used to determine which content data is to be reproduced based on one of the reproduction sequence information and the reproduction frequency parameters included in the read reproduction control information;
a selection part operable to select which content data is to be reproduced based on the information generated by the determination part; and

a reproduction part operable to read the content data selected by the selection part from the recording medium for reproduction.

As described above, in the sixth aspect, provided is a data recording and reproducing device which can change the reproduction frequency or order of content data both at random and sequential reproduction according to a user's preferences.

According to a seventh aspect, in the sixth aspect,

the determination part generates, based on the read reproduction control information, reproduction frequency parameters which indicate a reproduction frequency while the content data is randomly reproduced, and
the selection part randomly selects which content data is to be reproduced in such a manner as to satisfy the reproduction frequency indicated by the reproduction frequency parameters.

As described above, in the seventh aspect, provided is a data recording and reproducing device which can change the reproduction frequency of content data at random reproduction according to the user's preferences.

According to an eighth aspect, in the seventh aspect, the selection part comprises:

a random number generator generating a random number; and
a random number table for interrelating the random number with the content data, and is used to determine which content data is to be reproduced.

As described above, in the eighth aspect, provided is a data recording and reproducing device which can change a frequency of content data by using a random number generator and a random number table.

According to a ninth aspect, in the sixth aspect,

at normal reproduction, the determination part determines a reproduction order of the plurality of content data based on the reproduction sequence information in the read reproduction control information, and
the selection part selects the content data for reproduction in the reproduction order determined by the determination part.

As described above, in the ninth aspect, provided is a data recording and reproducing device which can change a reproduction order of content data according to the user's preferences when sequentially reproducing the content data.

According to a tenth aspect, in the sixth aspect,
the data recording and reproducing device further comprises an update part operable to update the reproduction control information recorded on the recording medium by writing new reproduction control information thereon.

As described above, in the tenth aspect, the reproduction control information can be appropriately updated. Therefore, provided is a data recording and reproducing device that can change the reproduction frequency or order of the content data.

According to an eleventh aspect, in the tenth aspect,
the update part updates the reproduction control information on the recording medium based on information relevant to the content data selected at normal reproduction.

As described above, in the eleventh aspect, the reproduction control information is updated at normal reproduction. Therefore, provided is a data recording and reproducing device which can change the reproduction frequency or order of the content data according to the user's preferences.

According to a twelfth aspect, in the sixth aspect,
the determination part includes a timer generating time information, and determines a reproduction frequency for each of the content data by using the time information generated by the timer.

As described above, in the twelfth aspect, provided is a data recording and reproducing device which calculates and changes the reproduction frequency or order by using time information provided by a timer.

A thirteenth aspect of the present invention is directed to a reproduction control information collection system in which an information provider collects reproduction control information about a reproduction frequency of a content reproduced by a user for sale to a content merchandiser, and rewards the user with a bonus for the reproduction control information, the system comprising:

a user's system provided on the user side;
an information provider's system provided on the information provider side; and
a content merchandiser's system provided on the content merchandiser side, wherein
the user's system, the information provider's system, and the merchandiser's system are interconnected with one another via a network for information exchange,
the user's system transmits the user's reproduction control information over the network,
the information provider's system receives the user's reproduction control information which came from the user's system, and transmits, over the network, the information together with an ID uniquely corresponds to the user to the content merchandiser's system,
in response to the reproduction control information and the ID provided by the information provider's system, the content merchandiser's system issues a password uniquely corresponds to the ID, and transmits the password to the information provider's system over the network,
the information provider's system transmits the password and the ID provided by the content merchandiser's system to the user's system over the network,
the user's system presents the ID and the password provided by the information provider's system to the content merchandiser's system over the network, and asks for the bonus, and
the content merchandiser's system identifies the user with the presented ID and password, and provides the bonus to the identified user.

As described above, in the thirteenth aspect, a user can be rewarded by a bonus meeting his/her tastes by offering his/her reproduction control information. Further, the user's personalized information is not provided directly to a content merchandiser. Still further, an information provider can get a reward from the content merchandiser by offering the user's information thereto. Still further, by receiving the user's reproduction control information, the content merchandiser can have a good grasp of the user's needs. Therefore, the content merchandiser can appropriately notify the user about any information on new contents and discount sale, thereby boosting the sale.

According to a fourteenth aspect, in the thirteenth aspect,
the user's system comprises:

a communications part operable to communicate with the information provider's system and the content merchandiser's system via the network; and
a reproduction control information management part operable to manage the user's reproduction control information for transmission to the information provider's system via the communications part with a predetermined timing,

the information provider's system comprises:

a communications part operable to communicate with the user's system and the content merchandiser's system via the network;
a user's information management part operable to manage information about the user in addition to the ID; and
a reproduction control information database for interrelating the reproduction control information, the ID, and any corresponding content with one another for storage, and

the content merchandiser's system comprises:

a communications part operable to communicate with the information provider's system and the user's system via the network;
a bonus offer part operable to provide the bonus to the user's system via the communications part; and
a password management part operable to issue and manage the password, and authenticating a correspondence between the ID and the password presented by the user's system.

These and other objects, features, aspects and advantages of the present invention will become more apparent from the following detailed description of the present invention when taken in conjunction with the accompanying drawings.

BRIEF DESCRIPTION OF THE DRAWINGS

FIG. 1 is a diagram showing the data structure of a recording medium according to a first embodiment of the present invention;
FIG. 2 is a diagram showing the data structure of a reproduction frequency indirect factor in the recording medium of the first embodiment;
FIG. 3 is a diagram showing the data structure of a reproduction frequency direct factor in the recording medium of the first embodiment;
FIG. 4 is a block diagram showing the structure of a data recording and reproducing device, and a recording medium according to a second embodiment of the present invention;
FIG. 5 is a flowchart showing the procedure for generating reproduction frequency information utilizing the reproduction frequency indirect factor in the second embodiment;
FIG. 6 is a diagram showing exemplary information obtained in step S504;
FIG. 7 is a diagram showing exemplary information obtained in step S505;
FIG. 8 is a diagram showing exemplary information obtained in step S507;
FIG. 9 shows an exemplary random number table specifically for data structure and data therein;
FIG. 10 is a flowchart showing an exemplary procedure for generating the reproduction frequency information utilizing the reproduction frequency direct factor in the second embodiment;
FIG. 11 is a flowchart showing an exemplary procedure for selecting content data;
FIG. 12 is a block diagram showing the structure of a data recording and reproducing device, and a recording medium according to a third embodiment of the present invention;
FIG. 13 is a flowchart showing an exemplary procedure for generating the reprcduction frequency information utilizing the reproduction frequency indirect factor in the third embodiment;
FIG. 14 is a diagrammatic sketch of a system for collecting reproduction control information, specifically for structure and operation thereof, according to a fourth embodiment of the present invention; and
FIG. 15 is a block diagram showing the detailed structure of the system for collecting reproduction control information of the fourth embodiment.

DESCRIPTION OF THE PREFERRED EMBODIMENTS

(First Embodiment)

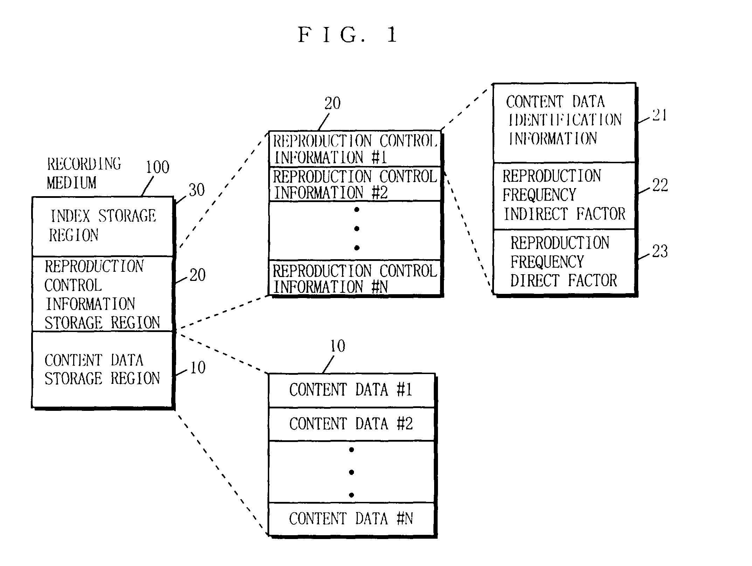

With reference to FIG. 1, described first is a recording medium according to a first embodiment of the present invention. FIG. 1 shows the data structure of a recording medium 100, which is a semiconductor memory. In FIG. 1, the recording medium 100 is provided with a content data storage region 10, a reproduction control information storage region 20, and an index storage region 30. The content data storage region 10 includes at least one or more content data. In the example of FIG. 1, the content data storage region 10 includes N content data numbered from #1 to #N. In this embodiment, the content data is presumed to be music data, and a format thereof is MP3 (MPEG1 Audio Layer3) . Here, the format is surely not limited thereto, and may be linear PCM (LPCM), for example. Further, the content data is not limited to music data, and may surely be video data, text data, or a combination thereof.

The reproduction control information storage region 20 stores at least one or more reproduction control information, which has one-to-one relationship with the content data. In this example, the content data #1 corresponds to the reproduction control information #1, the content data #2 to the reproduction control information #2, and the same goes for the rest.

Each reproduction control information includes content data identification information 21, a reproduction frequency indirect factor 22, and a reproduction frequency direct factor 23. The content data identification information 21 is used to identify which content data corresponds to the reproduction control information. The reproduction frequency indirect factor 22 is used to indirectly determine the reproduction frequency at random reproduction. The reproduction frequency direct factor 23 is used, as it is, as the reproduction frequency at random reproduction. As such, the reproduction frequency indirect factor 22 and the reproduction frequency direct factor 23 are both reproduction frequency parameters used to determine the reproduction frequency of the corresponding content data. Here, the reproduction control information does not necessarily include both of the reproduction frequency indirect factor 22 and the reproduction frequency direct factor 23.

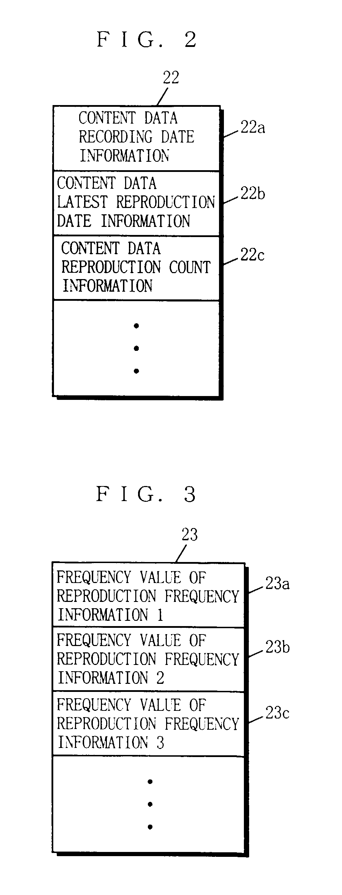

FIG. 2 shows the data structure of the reproduction frequency indirect factor 22. The reproduction frequency indirect factor 22 includes content data recording date information 22a, content data latest reproduction date information 22b, and content data reproduction count information 22c.

The content data recording date information 22a indicates when the corresponding content data was recorded on the recording medium 100. The content data latest reproduction date information 22b indicates when the corresponding content data was reproduced last time. The content data reproduction count information 22c indicates how many times the corresponding content data has been so far reproduced after recorded on the recording medium 100. Here, the reproduction frequency indirect factor 22 does not necessarily include the above three pieces of information, and may include at least one or more pieces of information relevant to the content data. The date indicated by the above information typically includes day, month, and year, but may not necessarily include all of them, or may additionally include time.

FIG. 3 shows the data structure of the reproduction frequency direct factor 23. The reproduction frequency direct factor 23 stores a value(s) representing the reproduction frequency of the corresponding content data. The reproduction frequency value is provided to reproduction frequency information, which is utilized in random reproduction, for example, in a data recording and reproducing device (later described).

In FIG. 3, the reproduction frequency direct factor 23 includes frequency values 23a, 23b, and 23c, respectively corresponding to the reproduction frequency information 1, 2, and 3. In other words, the reproduction frequency direct factor 23 includes three frequency values each has one-to-one relationship with the reproduction frequency information. This means the data recording and reproducing device (later described) can perform random reproduction with three different reproduction frequencies. Here, the number of values included in the reproduction frequency direct factor 23 is not restrictive, and one value is sufficient.

Referring back to FIG. 1, the index storage region 30 stores information (e.g., recording address) referred to by the data recording and reproducing device when fetching the content data in the content data storage region 10 and the reproduction control information in the reproduction control information storage region 20. In this embodiment, presumably, the index information storage region 30 stores information required by a FAT (File Allocation Table) file system, which controls the recording address. Here, the FAT file system is not restrictive, and may be other type of file system such as UDF (Universal Disk Format) , or no file system for managing the recording addresses.

In the foregoing, although the recording medium 100 is presumed to be a semiconductor memory, any rewritable recording medium will do as long as the recording control information can be updated thereon, for example, DVD-RAM.

(Second Embodiment)

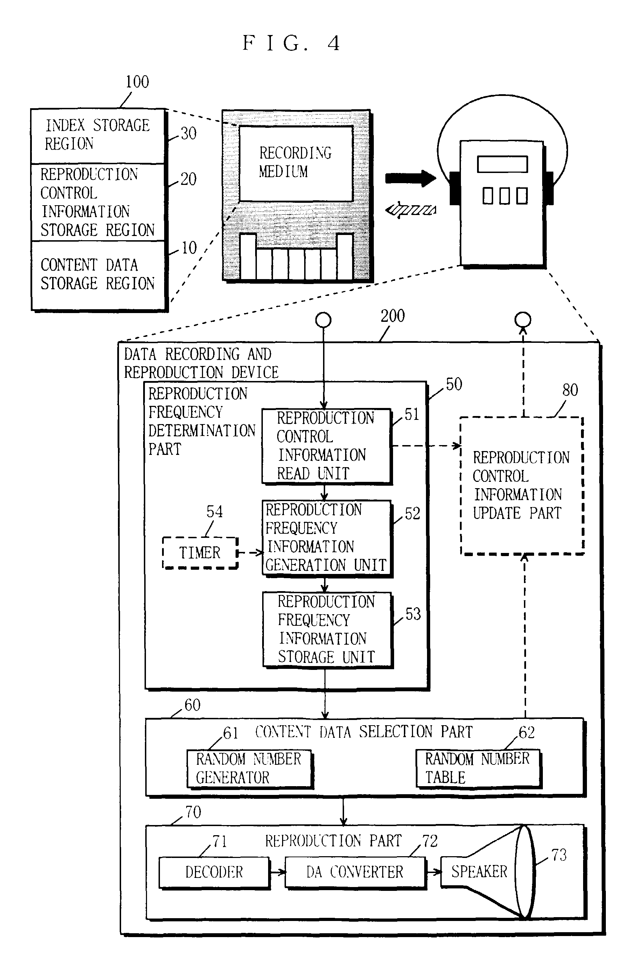

Described next is a data recording and reproducing device according to a second embodiment of the present invention. FIG. 4 shows the structure of the recording medium 100 in FIG. 1 and of a data recording and reproducing device 200 of this embodiment. The recording medium 100 is exemplarily a semiconductor memory such as SD (Secure Digital) card. The data recording and reproducing device 200 is exemplarily implemented by an audio player which records and reproduces digital data recorded on the recording medium 100.

In FIG. 4, the data recording and reproducing device 200 is provided with a reproduction frequency determination part 50, a content data selection part 60, and a reproduction part 70. The reproduction frequency determination part 50 reads the reproduction control information in the reproduction control information storage region 20 on the recording medium 100. Based on the reproduction control information read thereby, the reproduction frequency determination part 50 determines the reproduction frequency of the content data in the content data storage region 10. By referring to thus determined reproduction frequency, the content data selection part 60 randomly selects the content data to be reproduced. The reproduction part 70 reproduces thus selected content data.

Here, the present data recording and reproducing device is presumed to reproduce the content data under two methods of normal reproduction and special reproduction. In the normal reproduction method, the content data is reproduced in order of the reproduction control information #1 to #N in the reproduction control information storage region 20. At normal reproduction, the order is not necessarily started from the content data corresponding to the reproduction control information #1, and a user may arbitrarily select any content data from which reproduction is started. Or, the user may terminate the content data's reproduction halfway through, and select some other content data for reproduction. Note herein that, information about the order of the reproduction control information #1 to #N is referred to as reproduction sequence information. The reproduction sequence information is typically stored in the reproduction control information storage region 20, but may be stored in a region newly provided therefor. Next, in the special reproduction method, the reproduction order of content data is changeable depending on the reproduction frequency indirect factor 22 and the reproduction frequency direct factor 23 on the recording medium 100. In the embodiments of the present invention, reproduction is presumably performed under the special reproduction method unless otherwise the user arbitrarily selects the content data for reproduction.

Here, the data recording and reproducing device 200 may be additionally provided with a reproduction control information update part 80. The reproduction control information update part 80 updates the reproduction control information, which reflects the popularity of the content data. If this is the case, the reproduction control information corresponding to the content data reproduced in the data recording and reproducing device 200 is updated as required. For example, as for the reproduction control information, the reproduction control information update part 80 updates the reproduction date, the reproduction count, and the like, every time the corresponding content data is reproduced, or after every content data is thoroughly reproduced. Preferably, the reproduction control information update part 80 performs such update only at normal reproduction. This is because the user's preferences for content data is reflected in normal reproduction. Surely, the reproduction control information update part 80 may perform such update both at normal and special reproduction.

The reproduction frequency determination part 50 in the data recording and reproducing device 200 is provided with a reproduction control information read unit 51, a reproduction frequency information generation unit 52, and a reproduction frequency information storage unit 53. As shown by a dotted box in FIG. 4, the reproduction frequency determination part 50 may be additionally provided with a timer 54.

The content data selection part 60 includes a random number generator 61 and a random number table 62, which shows the corresponding between the random numbers and content data. The reproduction part 70 includes a decoder 71, a DA converter 72, and a speaker 73. Herein, the speaker 73 may be exemplarily implemented by a headphone, being externally connected to the reproduction part 70 via an audio output terminal.

Described in detail next below is the operation of the data recording and reproducing device 200 component-wise. First, the reproduction frequency determination part 50 reads the reproduction control information in the reproduction control information storage region 20 on the recording medium 100. Determined based thereon is the reproduction frequency of each content data in the content data storage region 10.

In the reproduction frequency determination part 50, the reproduction control information read unit 51 reads the reproduction control information recorded on the recording medium 100. Utilized for such reading is recording address information, for example, recorded in the index storage region 30.

By referring to such reproduction control information, the reproduction frequency information generation unit 52 generates the reproduction frequency information, which includes the reproduction frequency corresponding to each content data.

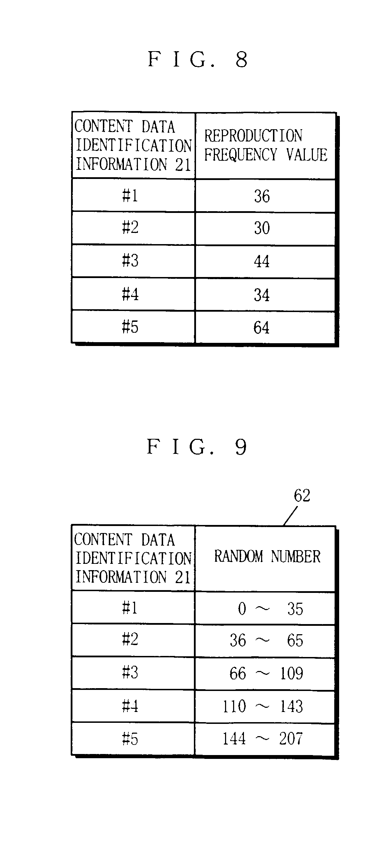

FIG. 8 shows an exemplary data structure of the reproduction frequency information. As shown in FIG. 8, the reproduction frequency information includes content data identification information 21, and the reproduction frequency values of content data at random reproduction. Here, the content data identification information 21 may be represented by a code such as ISRC (International Standard Recording Code) to identify music titles, for example.

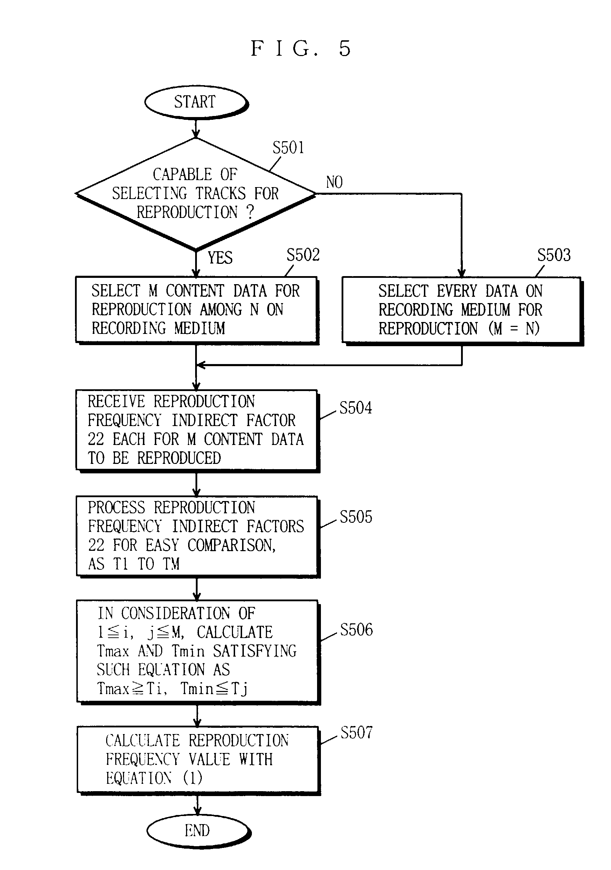

Described next is how to generate the reproduction frequency information in the reproduction frequency information generation unit 52, first by utilizing the reproduction frequency indirect factor 22. FIG. 5 is a flowchart showing the procedure for determining the reproduction frequency of each content data in the content data storage region 10 with the help of the reproduction frequency indirect factor 22.

In this example, in the course of generating the reproduction frequency information, referred to is the content data recording date information 22a in the reproduction frequency indirect factor 22, and followed is the procedure of FIG. 5, for example.

In step S501 in FIG. 5, the reproduction control information read unit 51 first checks whether the data recording and reproducing device 200 is capable of selecting content data for reproduction at random reproduction. Herein, M content data is to be selected out of N content data on the recording medium 100. If capable, the procedure goes to step S502, otherwise, goes to S503.

In step S502, the reproduction control information read unit 51 selects M content data for reproduction out of N content data on the recording medium 100. As for such selection, referred to may be a user's input or information on the recording medium 100. Thereafter, the procedure goes to step S504.

In step S503, the reproduction control information read unit 51 selects every content data on the recording medium 100, that is, M = N. The procedure then goes to step S504.

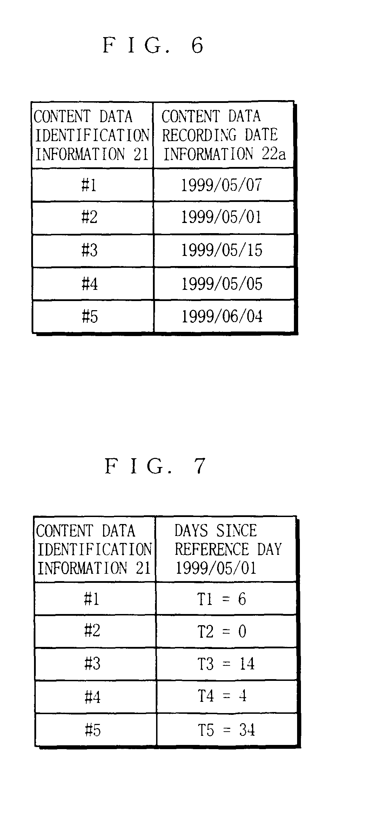

In step S504, the reproduction frequency information generation unit 52 receives, from the reproduction control information read unit 51, the content data recording date information 22a of M content data. Shown in FIG. 6 is thus received exemplary data.

In step S505, the reproduction frequency information generation unit 52 works on the content data recording date information 22a of #1 to #M content data to make date information therein easy to compare with one another. In this example, the date information is represented by T1 to TM, each indicates the number of days since a reference date. The reference date is assumed to be the earliest among dates corresponding to M content data. FIG. 7 shows, on the basis of FIG. 6, values of T1 to T5 on the assumption that the reference date is May 1, 1999.

In step S506, among T1 to TM of M content data, the one maximum in value is regarded as Tmax, minimum as Tmin. Accordingly, Tmax corresponds to the-most-recently-recorded content data. In the example of FIG. 7, Tmax = 34, and Tmin = 0.

In step S507, the reproduction frequency information generation unit 52 calculates the reproduction frequency for each content data with the following equation (1). Here, there needs to satisfy $1 \leqq i \leqq M$, and a maximum value obtainable by the equation (1) for the reproduction frequency should be an integer not more than the value.

$$[\text{EQUATION 1}]$$

$$\text{REPRODUCTION FREQUENCY VALUE} = \left[ \text{MINIMUM FREQUENCY VALUE} + \frac{Ti - Tmin}{Tmax - Tmin} \times \text{WEIGHTING REFERENCE VALUE} \right] \cdots (1)$$

In the above equation (1), the weighting reference value is a parameter determining influence of the content data recording date information 22a on the reproduction frequency value, and is nonnegative in value. The larger the weighting reference value, the more apparent the influence of the content data recording date information 22a on the reproduction frequency value becomes. The minimum frequency value is assigned equally to M content data to be reproduced, and is nonnegative in value. The minimum frequency value may be surely be 0.

FIG. 8 shows the result obtained by substituting specific values in the above equation (1) on the basis of the example of FIG. 7. Specifically, the minimum frequency value is 30, and the weighting reference value 34. In FIG. 8, the reproduction frequency value corresponding to the content data #1 will be [30 + (6 - 0/34 - 0) $\times$ 34] = 36.

This is the end of the procedure in FIG. 5, and thus the reproduction frequency information is generated. Here, the above equation (1) exemplarily applied in step S507 is not restrictive, and any equation will do as long as the reproduction control information read by the reproduction control information read unit 51 is a parameter for generating the reproduction frequency information.

Alternatively, in the course of generating the reproduction frequency information, time information provided by the timer 54 and time information included in the reproduction control information may be both referred to. In such case, by referring to the time information provided by the timer 54, the reference date in step S505 may be a date at reproduction. Here, the time information typically indicates the current time denoted by day, month, and year, but may not necessarily include all of them, or may additionally include time.

As described in the foregoing, with the help of the content data recording date information 22a on the recording medium 100, the currently recorded content data can be increased in reproduction frequency. Accordingly, the user's preferences for the content data can be automatically reflected in the reproduction frequency information.

Alternatively, the content data latest reproduction date information 22b and the content data reproduction count information 22c may also be used to generate the reproduction frequency information. The procedure therefor is the same as the one in the above, and thus is not described again.

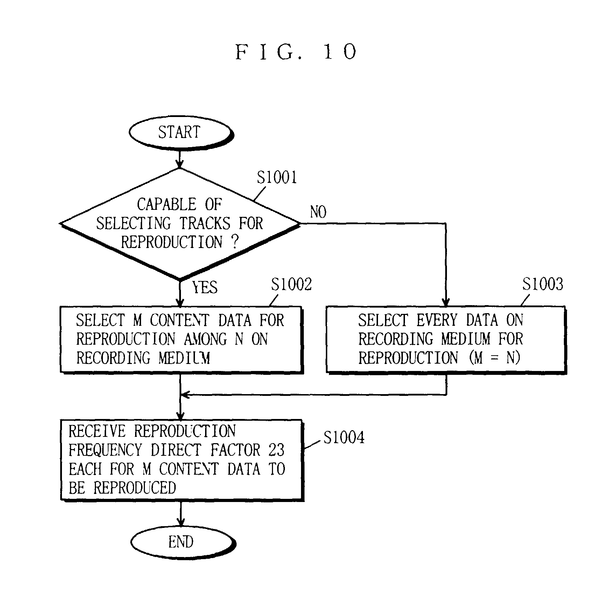

Described next is how to generate the reproduction frequency information in the reproduction frequency information generation unit 52, by utilizing the reproduction frequency direct factor 23 this time. FIG. 10 is a flowchart showing the procedure for determining the reproduction frequency of each content data in the content data storage region 10 with the help of the reproduction frequency direct factor 23. In this example, in the course of generating the reproduction frequency information, referred to is the frequency value 23a of the reproduction frequency information 1, and followed is the procedure of FIG. 10, for example.

Steps S1001 to S1003 in FIG. 10 are equal in operation to steps S501 to S503 in FIG. 5. That is, the reproduction control information read unit 51 first checks whether the data recording and reproducing device 200 is capable of selecting content data for reproduction (step S1001). If capable, M content data to be reproduced is selected out of N content data on the recording medium 100 (step S1002). Otherwise, every content data on the recording medium 100 is selected for reproduction (step S1003).

Next, in step S1004, the reproduction frequency information generation unit 52 receives, from the reproduction control information read unit 51, the frequency value 23a of the reproduction frequency information 1 for M content data, and regards the value 23a as the reproduction frequency at random reproduction.

This is the end of the procedure in FIG. 10, and thus the reproduction frequency information is generated. As such, the reproduction frequency direct factor 23 utilized for determining the reproduction frequency eases the procedure than the reproduction frequency indirect factor 22.

Accordingly, for example, the reproduction control information update part 80 may so operate as to record, on the recording medium 100, the reproduction frequency calculated by utilizing the reproduction frequency indirect factor 22 as the reproduction frequency direct factor 23.

Here, the frequency value 23a used in the above example is not restrictive. Also, the information referred to in the course of generating the reproduction control information is not limited in one type, and the information in the reproduction frequency indirect factor 22 and the reproduction frequency direct factor 23 may be combined in a predetermined manner for use.

As is known from the above, once the reproduction frequency information is generated in the reproduction frequency information generation unit 52, the reproduction frequency information storage unit 53 stores the generated reproduction frequency information therein.

Next, the content data selection part 60 selects content data to be reproduced by referring to the reproduction frequency information determined by the reproduction frequency determination part 50. In FIG. 4, the content data selection part 60 includes the random number generator 61 and the random number table 62. Hereinafter, the operation of the content data selection part 60 is described.

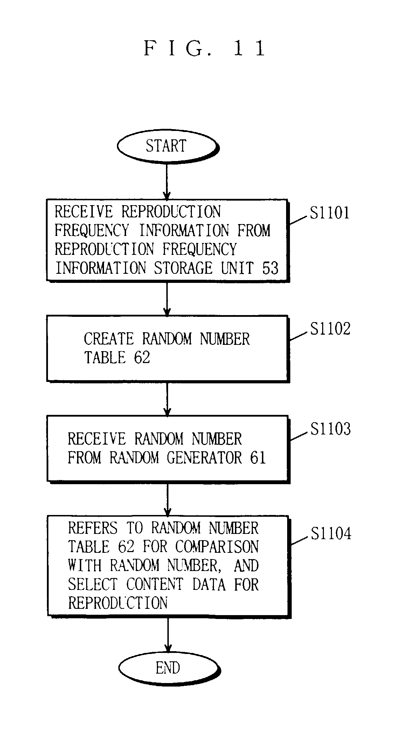

FIG. 11 is a flowchart showing an exemplary procedure for selecting content data to be reproduced. In step S1101 in FIG. 11, the content data selection part 60 fetches the reproduction frequency information stored in the reproduction frequency information storage unit 53.

In step S1102, the content data selection part 60 then makes use of thus fetched reproduction frequency information to generate the random number table 62. Here, there needs to concern a characteristic of the random number generator 61, i.e., which value is generated in which probability. In this example, the random generator 61 is presumed to generate nonnegative integers (0 to RANDMAX) with the same probability, and RANDMAX should be large enough.

FIG. 9 shows an exemplary random number table 62 created on the basis of the reproduction frequency information in FIG. 8. In the example of FIG. 9, each content data is assigned random numbers, in ascending order from 0, in such a manner that the number of rows in the table for the random numbers is equalized to that for the reproduction frequency value. In the table of FIG. 9, 208 values of 0 to 207 are assigned to the content data.

In step S1103, the content data selection part 60 fetches any random number being a positive integer from the random number generator 61. In step S1104, the content data selection part 60 then refers to the random number table 62 for comparison with thus fetched random number, and then selects content data for reproduction. In the case of using the random number table 62 of FIG. 9, the fetched random number is not always in the range of 0 to 207. Therefore, a random number fetched in step S1103 is once divided by 208, and thus calculated reminder is used. By referring to FIG. 9, when the reminder is 59, the content data #2 is selected, and when 203, the content data #5. In such manner, the content data is selected to be reproduced.

The reproduction part 70 in FIG. 4 reproduces such selected content data. The selected content data (here, MP3 music data) becomes audible from the speaker 73 after decoded by the decoder 71, and then D/A converted by the DA converter 72.

If equipped, the reproduction control information update part 80 updates the reproduction control information in the reproduction control information storage region 20 depending on the popularity of the content data. Such operation has been already described.

Herein, the audio player which records and reproduces data exemplarily implementing the data recording and reproducing device 200 in the above is not restrictive, and any data recording and reproducing device will do as long as digital data can be recorded and reproduced therein. As for the recording medium 100, as already described above, any will do as long as rewritable.

(Third Embodiment)

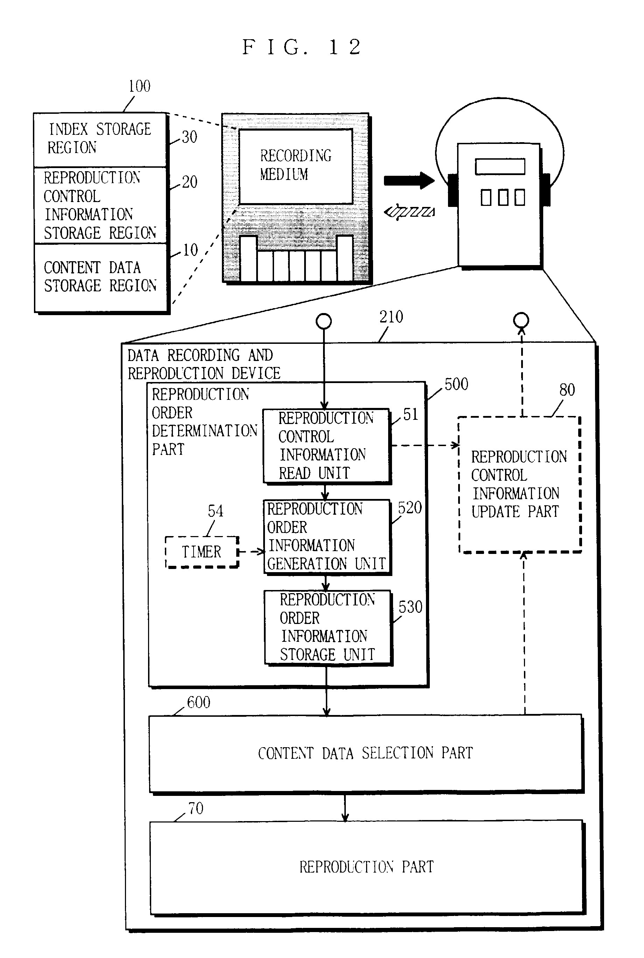

Described next is a data recording and reproducing device according to a third embodiment of the present invention. FIG. 12 is a diagram showing the structure of the recording medium 100 in FIG. 1 and of a data recording and reproducing device 210 of this embodiment.

In FIG. 12, the data recording and reproducing device 210 is provided with a reproduction order determination part 500, a content data selection part 600, and the reproduction part 70. The reproduction order determination part 500 reads the reproduction control information, and then determines the order of the content data for reproduction. By referring to thus determined reproduction order, the content data selection part 600 selects the content data. In this embodiment, the reproduction part 70 and the reproduction control information update part 80 are identical to those in the data recording and reproducing device 200 of FIG. 4, and thus are under the same reference numerals and not described again.

The reproduction order determination part 500 in the data recording and reproducing device 210 includes the reproduction control information read unit 51, a reproduction order information generation unit 520, and a reproduction order information storage unit 530. In this embodiment, the reproduction control information read unit 51 and the timer 54 are identical those in the reproduction frequency determination part 50 of FIG. 4, and thus are under the same reference numerals and not described again.

Described in detail next is the operation of the data recording and reproducing device 210 component-wise, focusing on any difference from the data recording and reproducing device 200 of FIG. 4. First, the reproduction order determination part 500 reads the reproduction control information in the reproduction control information storage region 20 on the recording medium 100. Determined based thereon is the reproduction order of the content data in the content data storage region 10.

In the reproduction order determination part 500, the reproduction order information generation unit 520 refers to the reproduction control information read by the reproduction control information read unit 51 so as to generate reproduction order information, which includes the reproduction order of the content data. The reproduction order information is similar in data structure to the reproduction frequency information in FIG. 8, and includes the content data identification information 21 and values representing the reproduction order of the content data.

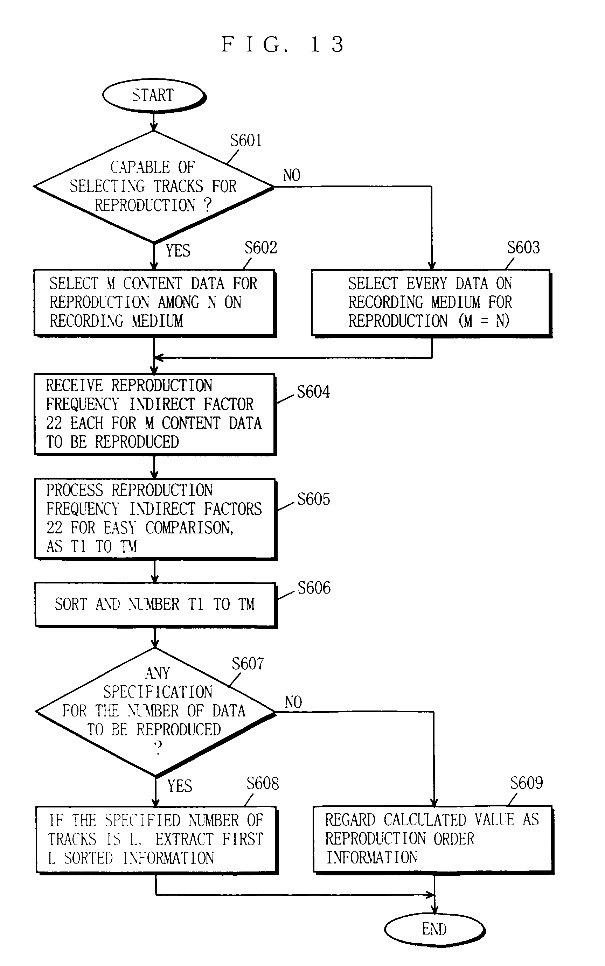

Described now is how to generate the reproduction order information in the reproduction order information generation unit 520, first utilizing the reproduction frequency indirect factor 22. FIG. 13 is a flowchart showing an exemplary procedure for determining the reproduction order of the content data in the content data storage region 10 with the help of the reproduction frequency indirect factor 22.

In this example, as is the case of FIG. 5, referred to in the course of generating the reproduction order information is the content data recording date information 22a in the reproduction frequency indirect factor 22, and followed is the procedure of FIG. 13, for example.

Steps S601 to S605 in FIG. 13 are exactly the same as steps S501 to S505 in FIG. 5, and are not described again. In step S606 in FIG. 13, the reproduction order information generation unit 520 sorts the number of days since the reference date represented by TI to TM in FIG. 7 in an ascending or descending numeric order so as to number.

In step S607, the reproduction order information generation unit 520 checks whether a user has specified the number of content data (tracks) to reproduce in the data recording and reproducing device 210. If specified, the procedure goes to step S608, otherwise, goes to step S609.

In step S608, assuming that the specified number of tracks is L, the reproduction order information generation unit 520 extracts the first L data out of M data sorted in step S606, and then deletes the not-extracted data. Thereafter, the procedure goes to step S609.

In step S609, the reproduction order information generation unit 520 stores thus generated data in the reproduction order information storage unit 530 as the reproduction order information.

Here, in the course of generating the reproduction order information, as in the case of generating the reproduction frequency information, the time information provided by the timer 54 may be also referred to.

As described in the foregoing, the content data recording date information 22a on the recording medium 100 can change the reproduction order. Specifically, when data is sorted in an ascending numeric order, the currently-recorded content data is reproduced early, and in a descending numeric order, on the other hand, the previously-recorded content data is reproduced early. Therefore, the user's preferences for the content data can be automatically reflected in the reproduction order information.

Alternatively, the content data latest reproduction date information 22b and the content data reproduction count information 22c may also be used to generate the reproduction order information. The procedure therefor is the same as the one in the above, and thus is not described again.

Moreover, the reproduction order information is generated almost in the same manner regardless of which is utilized in the course thereof, the reproduction frequency direct factor 23 and the reproduction frequency indirect factor 22. A difference therebetween is only that, in step S605 of FIG. 13, there is no need to work on the reproduction frequency direct factor 23 for the purpose of easy comparison.

Here, the frequency value 23a used in the above example is not restrictive. Also, the information referred to in the course of generating the reproduction control information is not limited in one type, and the information in the reproduction frequency indirect factor 22 and the reproduction frequency direct factor 23 may be combined in a predetermined manner for use.

Next, the content data selection part 600 in FIG. 12 sequentially selects the content data to be reproduced based on the reproduction order information determined by the reproduction order determination part 500. The content data selection part 60 then reproduces thus selected content data.

If equipped, the reproduction control information update part 80 updates the reproduction control information, which reflects the popularity of the content data. Such operation has been already described.

Note that, the above embodiment is no more than a system example which is expected to achieve optimal results under the present circumstances. Therefore, numerous other modifications and variations can be devised without departing from the scope of the invention. For example, as is the data recording and reproducing device 200, the data recording and reproducing device 210 may be any type as long as digital data can be recorded and reproduced therein. As for the recording medium 100, as already described above, any will do as long as rewritable.

(Fourth Embodiment)

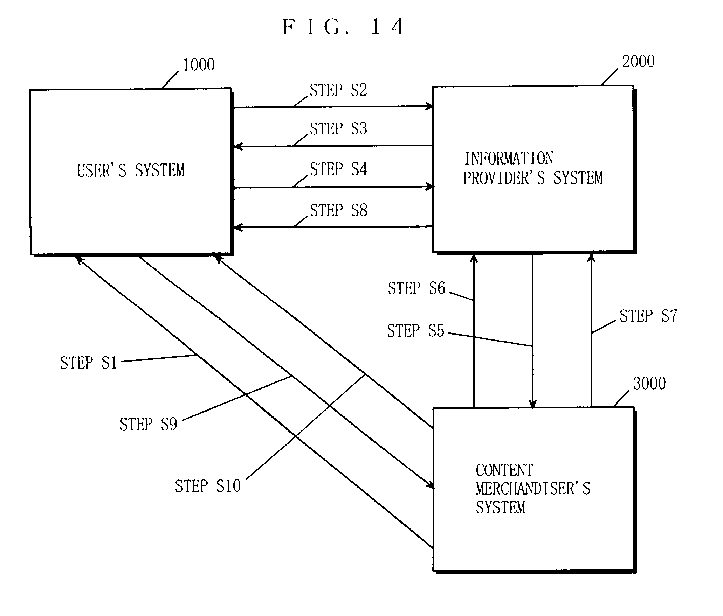

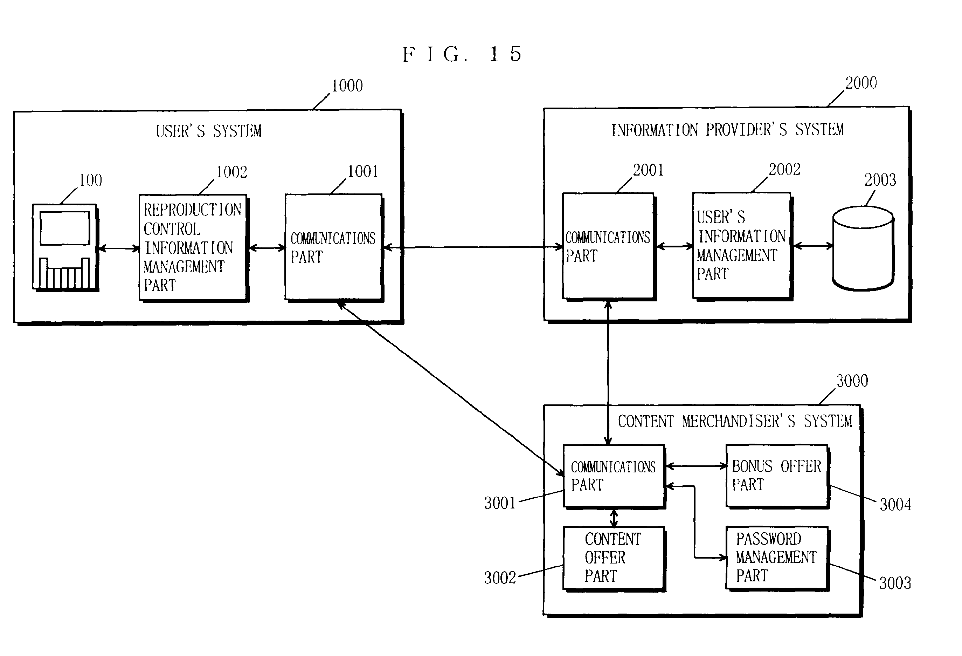

Described first is the need for a system according to a fourth embodiment of the present invention. The above-described reproduction control information used by the recording medium and the data recording and reproducing device indicates the user's preferences for the content data. Therefore, such reproduction control information is quite beneficial for content merchandisers to know the users' preferences. The issue here is, for the users, there is no need to bother to offer such personalized information to the content merchandisers. In consideration thereof, if the reproduction control information provided by arbitrary users can be efficiently collected and utilized, such system comes in useful. With reference to FIGS. 14 and 15, such system is described.

FIG. 14 is a conceptual diagram showing how the system of the fourth embodiment works. In FIG. 14, the system includes a user's system 1000, an information provider's system 2000, and a content merchandiser's system 3000, all of which are interconnected with one another via a communications network, typically the Internet. Such structure is for the information provider to collect and manage the reproduction control information on the user's recording medium and providing the information to the content merchandiser. Next below, the operation of the system is described step-wise.

In step SI of FIG. 14, a content merchandiser sells content data such as music to a user. Thus sold content data is transmitted from the content merchandiser's system 3000 to the user's system 1000. Here, such on-line distribution is not restrictive, and the content data may be recorded on a recording medium and distributed in stores, for example.

In step S2, the user applies for membership to the information provider to be rewarded for his/her offering reproduction control information. Specifically, membership information including the user's name, address, e-mail address, and the like, is transmitted from the user's system 1000 to the information provider's system 2000. The membership information is used to uniquely identify the user. Here, such on-line application is not restrictive, and the user may make an application by mail or phone, for example.

In step S3, in response to the user's membership application, the information provider issues a membership ID uniquely for the user. To be specific, the information provider's system 2000 refers to thus received membership information, and then transmits the user's membership ID to the user's system 1000 by e-mail, for example. Surely, such on-line notification is not restrictive, and the user may be notified about his/her membership ID by mail or phone, for example.

In step S4, the user provides the information provider, after a predetermined time interval, for example, with his/her reproduction control information about the content data he/she bought. Specifically, such reproduction control information is transmitted from the user's system 1000 to the information provider's system 2000 after an arbitrary time interval. As such, the information provider's system 2000 collects users' reproduction control information, and if the content merchandisers are plurally exist, classifies the information according to the content merchandiser for storage.

In step S5, the information provider provides the content merchandiser with the user's reproduction control information. Specifically, the information provider's system 2000 transmits, to the content merchandiser's system 3000, a part of the reproduction control information needed by the content merchandiser together with the user's membership ID. The reason for transmitting the user's membership ID is to conceal the user's name and keep his/her other personalized information safe.

In step S6, the content merchandiser pays for the reproduction control information to the information provider. Specifically, the content merchandiser's system 3000 makes on-line payment with respect to the information provider's system 2000 by using digital cash. Here, on-line payment is not restrictive, and payment by bank transfer or sending cash may be also a possibility.

In step S7, the content merchandiser notifies the information provider about a password for bonus together with the user's membership ID. To be specific, the content merchandiser's system 3000 creates a password to allow only the applicable user to receive the bonus, and then transmits the password together with the use's membership ID to the information provider's system 2000. Here, the password may be created by the information provider, and then is notified to the content provider together with the corresponding ID.

In step S8, the information provider receives the password from the content merchandiser, and then notifies the password to the user. In addition to the password, the information provider may notify the user about information on the bonus offered by the content merchandiser. Specifically, the information provider's system 2000 refers to the received membership information, and then transmits the user's password and bonus information to the user's system 1000. Here, such on-line notification is not restrictive, and the user may be notified about the password by mail or phone, for example.

In step S9, the user asks the content merchandiser for the bonus by using his/her membership ID and password provided by the information provider. To be specific, the user's system 1000 transmits the membership ID and password to the information provider's system 2000, and then asks for transmitting the bonus, for example.

In step S10, in response to thus notified membership ID and password, the information provider authenticates the user's identity. If confirmed, the information provider offers the bonus to the user. Specifically, the information provider's system 2000 authenticates the membership ID and password provided by the user's system 1000 whether the user can be authenticated. If the user's identity is confirmed, the bonus is transmitted. Here, the bonus may vary to free or sample content data, discount or privilege, a point exchangeable with merchandise or service depending on how many, or information about new content data, anything is possible as long as the bonus attracts the users well enough.

Described next is the detailed structure of the present system. FIG. 15 is a block diagram showing the structure of the user's system 1000, the information provider's system 2000, and the content merchandiser's system 3000.

In FIG. 15, the user's system 1000 includes the recording medium 100 of the first embodiment, a reproduction control information management part 1002 for managing the reproduction control information recorded on the recording medium 100, and a communications part 1001 for external communications. The information provider's system 2000 includes a communications part 2001 for external communications, a user's information management part 2002 for managing information about users, and a reproduction control information database 2003 for storing the user's reproduction control information. As for the content merchandiser's system 3000, included are a communications part 3001 for external communications, a content offer part 3002 for offering content data at cost to the user, a password management part 3003 for managing a password corresponds to the user's ID, and a bonus offer part 3004 for offering a bonus for the user. These systems are interconnected with one another via a communications network, typically the Internet. Next below, the operation of the system is described component-wise.

In the user's system 1000, the recording medium stores information which includes both reproduction control information and content data as already described in the first embodiment. The content data has been, as already described in step S1 of FIG. 14, transmitted from the content merchandiser's system 3000 typically over the communications network.

The reproduction control information management part 1002 manages the reproduction control information on the recording medium 100, and provides such information to the communications part 1001 for transmission therefrom, typically after a predetermined time interval. Here, the communications part 1001 performs transmission after the reproduction control information stored therein reaches a predetermined volume, or in response to the user's instruction. Further, the recording control management part 1002 may be partially or entirely placed in the data recording and reproducing device described in the second embodiment.

The communications part 1001 may be composed of a modem or a dial-up rooter, for example, and communicates with the information provider's system 2000 or the content merchandise's system 3000 typically via the Internet for information exchange. Such operation is already described in the above with reference to FIG. 14.

Here, the user's system 1000 may be additionally provided with a user terminal (not shown) , and therethrough, the user makes a membership application, receives his/her membership ID and password, and the like. Typically, the user terminal is a personal computer having a software installed therein to receive/send e-mails and access web pages.

In the information provider's system 2000, the communications part 2001 is identical in structure and operation to the communications part 1001. The user's information management part 2002 manages various types of information (e.g., user's personalized information, ID) came from the user's system 1000 via the communications part 2001, information such as password provided by the content merchandiser's system 3000, and the like. The user's information management part 2002 manages the user's reproduction control information, and provides the information to the reproduction control information database 2003. In the reproduction control information database 2003, created and stored is a database having interrelated the reproduction control information, membership ID, type and title of the content data, the merchandiser, and the like. Such stored reproduction control information is classified according to the content merchandiser, and is transmitted to the information provider's systems including the information provider's system 2000.

Here, the information provider's system 2000 may additionally include a display part (not shown) for displaying statistical information about the reproduction control information stored in the reproduction control information database 2003. Specifically, the display part analyzes the reproduction control information stored in the reproduction control information database 2003, and then sorts the content data reproduced by the user in order of the reproduction frequency. Then, the display part displays, exemplarily on a web page, content charts telling which contents are now popular. Such charts draw the users' interests toward those contents, and thus the sale of those contents can be boosted.

In the content merchandiser's system 3000, the communications part 3001 is identical in structure and operation to the communications part 1001. The content offer part 3002 stores content data for sale to the user, and sells that responding to the user's request. Here, the content offer part 3002 is not essential in the system as is already described.

The password management part 3003 generates, stores, and manages a password uniquely corresponds to the user's ID. In the case that the information provider's system 2000 is the one which generates such password, the password management part 3003 receives and manages the password. The bonus offer part 3004 offers bonus responding to the user's request. To be specific, the bonus offer part 3004 receives the user's ID and password, and inquires the password management part 3003 whether the password is the correct one. The password management part 3004 decides whether the user's request for the bonus is valid by referring to the correspondence between the ID and password. If the user's password is determined as being correct, the bonus offer part 3004 transmits the bonus predetermined for the ID, or increases the user's point, for example. Or, the bonus offer part 3004 may allow the user to access any web page, which is generally unaccessible. Here, the bonus selection will be effective if the user's reproduction control information is referred to. If so, the user's preferences are properly reflected in his/her bonus to-receive, and accordingly the sale of contents can be boosted.

As such, according to the present system, the user can be rewarded by a bonus meeting his/her tastes by offering his/her reproduction control information. Further, since the user's personalized information is not provided directly to the content merchandiser, the user does not bother to receive any unwanted information. Still further, the information provider can get a reward from the content merchandiser by offering, in database form, the user's information thereto. Still further, by receiving the user's information, the content merchandiser can have a good grasp of the user's needs. Therefore, the content merchandiser can appropriately notify the user about any information on new contents and discount sale, thereby boosting the sale.

While the invention has been described in detail, the foregoing description is in all aspects illustrative and not restrictive. It is understood that numerous other modifications and variations can be devised without departing from the scope of the invention.

**Claims**

1. A recording medium (100) for storing digital data to be read/updated by a data recording and reproducing device (200, 210),
   the digital data comprising:

   a plurality of content data (10) reproducable by the data recording and reproducing device (200, 210); and
   reproduction control information (20) used to determine the content data (10) to be reproduced, wherein
   the reproduction control information (20) includes reproduction sequence information (20) which determines
   a reproduction order of the plurality of content data (10) while the data recording and reproducing device (200, 210) performs normal reproduction, and reproduction frequency parameters (22, 23) each of which determines reproduction frequency of the content data (10) while the data recording and reproducing device (200, 210) performs special reproduction, the reproduction frequency parameters (22, 23) being updatable.

**2.** The recording medium (100) according to claim 1, wherein
the reproduction frequency parameters (22, 23) are updated according to information relevant to the content data (10) selected at normal reproduction.

**3.** The recording medium (100) according to claim 1, wherein
the reproduction control information (20) includes information (22a) about date and time while the content data (10) is recorded.

**4.** The recording medium (100) according to claim 1, wherein
the reproduction control information (20) includes information (22b) about date and time while the content data (10) is reproduced last time.

**5.** The recording medium (100) according to claim 1, wherein
the reproduction control information (20) includes information (22c) about the number of times the content data (10) has been reproduced.

**6.** A data recording and reproducing device (200, 210) for reproducing digital data to be read/updated in the recording medium (100) of claim 1, the device comprising:

a determination part (50, 500) operable to read the reproduction control information (20) from the recording medium (100), and generate information used to determine which content data (10) is to be reproduced based on one of the reproduction sequence information (20) and the reproduction frequency parameters (22, 23) included in the read reproduction control information (20);
a selection part (60, 600) operable to select which content data (10) is to be reproduced based on the information generated by the determination part (50, 500); and
a reproduction part (70) operable to read the content data (10) selected by the selection part (60, 600) from the recording medium (100) for reproduction.

**7.** The data recording and reproducing device (200) according to claim 6, wherein

the determination part (50) generates, based on the read reproduction control information (20), reproduction frequency parameters (22, 23) which indicate a reproduction frequency while the content data (10) is randomly reproduced, and
the selection part (60) randomly selects which content data (10) is to be reproduced in such a manner as to satisfy the reproduction frequency indicated by the reproduction frequency parameters (22, 23).

**8.** The data recording and reproducing device (200) according to claim 7, wherein        the selection part (60) comprises:

a random number generator (61) generating a random number; and
a random number table (62) for interrelating the random number with the content data (10), and is used to determine which content data (10) is to be reproduced.

**9.** The data recording and reproducing device (210) according to claim 6, wherein,

at normal reproduction, the determination part (500) determines a reproduction order of the plurality of content data (10) based on the reproduction sequence information in the read reproduction control information (20), and
the selection part (600) selects the content data (10) for reproduction in the reproduction order determined by the determination part (500).

**10.** The data recording and reproducing device (200, 210) according to claim 6, further comprising an update part (80) operable to update the reproduction control information (20) recorded on the recording medium (100) by writing new reproduction control information (20) thereon.

**11.** The data recording and reproducing device (200, 210) according to claim 10, wherein
the update part (80) updates the reproduction control information (20) on the recording medium (100) based on information relevant to the content data (10) selected at normal reproduction.

**12.** The data recording and reproducing device (200, 210) according to claim 6, wherein
the determination part (50, 500) includes a timer (54) generating time information, and determines a reproduction frequency for each of the content data (10) by using the time information generated by the timer (54).

**13.** A reproduction control information collection system in which an information provider collects reproduction control information (20) about a reproduction frequency of a content reproduced by a user for sale to a content merchandiser, and rewards the user with a bonus for the reproduction control information (20), the system comprising:

a user's system (1000) provided on the user side;
an information provider's system (2000) provided on the information provider side; and
a content merchandiser's system (3000) provided on the content merchandiser side, wherein
the user's system (1000), the information provider's system (2000), and the merchandiser's system (3000) are interconnected with one another via a network for information exchange,
the user's system (1000) transmits the user's reproduction control information (20) over the network,
the information provider's system (2000) receives the user's reproduction control information (20) which came from the user's system (1000), and transmits, over the network, the information together with an ID uniquely corresponds to the user to the content merchandiser's system (3000),
in response to the reproduction control information (20) and the ID provided by the information provider's system (2000) , the content merchandiser's system (3000) issues a password uniquely corresponds to the ID, and transmits the password to the information provider's system (2000) over the network,
the information provider's system (2000) transmits the password and the ID provided by the content merchandiser's system (3000) to the user's system (1000) over the network,
the user's system (1000) presents the ID and the password provided by the information provider's system (2000) to the content merchandiser's system (3000) over the network, and asks for the bonus, and
the content merchandiser's system (3000) identifies the user with the presented ID and password, and provides the bonus to the identified user.

**14.** The reproduction control information collection system according to claim 13, wherein
the user's system (1000) comprises:

a communications part (1001) operable to communicate with the information provider's system (2000) and the content merchandiser's system (3000) via the network; and
a reproduction control information management part (1002) operable to manage the user's reproduction control information (20) for transmission to the information provider's system (2000) via the communications part (1001) with a predetermined timing,

the information provider's system (2000) comprises:

a communications part (2001) operable to communicate with the user's system (1000) and the content merchandiser's system (3000) via the network;
a user's information management part (2002) operable to manage information about the user in addition to the ID; and
a reproduction control information database (2003) for interrelating the reproduction control information(20), the ID, and any corresponding content with one another for storage, and

the content merchandiser's system (3000) comprises:

a communications part (3001) operable to communicate with the information provider's system (2000) and the user's system (1000) via the network;
a bonus offer part (3004) operable to provide the bonus to the user's system (1000) via the communications part (3001); and
a password management part (3003) operable to issue and manage the password, and authenticating a correspondence between the ID and the password presented by the user's system (1000) .

EP 1 107 255 A2

# F I G .  1

## F I G .  2

22

| CONTENT DATA RECORDING DATE INFORMATION | 22a |
| CONTENT DATA LATEST REPRODUCTION DATE INFORMATION | 22b |
| CONTENT DATA REPRODUCTION COUNT INFORMATION | 22c |
| . . . | |

## F I G .  3

23

| FREQUENCY VALUE OF REPRODUCTION FREQUENCY INFORMATION 1 | 23a |
| FREQUENCY VALUE OF REPRODUCTION FREQUENCY INFORMATION 2 | 23b |
| FREQUENCY VALUE OF REPRODUCTION FREQUENCY INFORMATION 3 | 23c |
| . . . | |

F I G. 4

# F I G. 5

START

S501
CAPABLE OF
SELECTING TRACKS FOR
REPRODUCTION ?

NO →

YES

S502
SELECT M CONTENT DATA FOR
REPRODUCTION AMONG N ON
RECORDING MEDIUM

S503
SELECT EVERY DATA ON
RECORDING MEDIUM FOR
REPRODUCTION (M = N)

S504
RECEIVE REPRODUCTION
FREQUENCY INDIRECT FACTOR
22 EACH FOR M CONTENT DATA
TO BE REPRODUCED

S505
PROCESS REPRODUCTION
FREQUENCY INDIRECT FACTORS
22 FOR EASY COMPARISON,
AS T1 TO TM

S506
IN CONSIDERATION OF
$1 \leq i$, $j \leq M$, CALCULATE
Tmax AND Tmin SATISFYING
SUCH EQUATION AS
$Tmax \geq Ti$, $Tmin \leq Tj$

S507
CALCULATE REPRODUCTION
FREQUENCY VALUE WITH
EQUATION (1)

END

F I G. 6

| CONTENT DATA IDENTIFICATION INFORMATION 21 | CONTENT DATA RECORDING DATE INFORMATION 22a |
|---|---|
| #1 | 1999/05/07 |
| #2 | 1999/05/01 |
| #3 | 1999/05/15 |
| #4 | 1999/05/05 |
| #5 | 1999/06/04 |

F I G. 7

| CONTENT DATA IDENTIFICATION INFORMATION 21 | DAYS SINCE REFERENCE DAY 1999/05/01 |
|---|---|
| #1 | T1 = 6 |
| #2 | T2 = 0 |
| #3 | T3 = 14 |
| #4 | T4 = 4 |
| #5 | T5 = 34 |

F I G .  8

| CONTENT DATA IDENTIFICATION INFORMATION 21 | REPRODUCTION FREQUENCY VALUE |
|---|---|
| #1 | 36 |
| #2 | 30 |
| #3 | 44 |
| #4 | 34 |
| #5 | 64 |

F I G .  9

62

| CONTENT DATA IDENTIFICATION INFORMATION 21 | RANDOM NUMBER |
|---|---|
| #1 | 0 ～ 35 |
| #2 | 36 ～ 65 |
| #3 | 66 ～ 109 |
| #4 | 110 ～ 143 |
| #5 | 144 ～ 207 |

F I G. 1 0

START

S1001
CAPABLE OF
SELECTING TRACKS FOR
REPRODUCTION ?

NO

YES

S1002
SELECT M CONTENT DATA FOR
REPRODUCTION AMONG N ON
RECORDING MEDIUM

S1003
SELECT EVERY DATA ON
RECORDING MEDIUM FOR
REPRODUCTION (M = N)

S1004
RECEIVE REPRODUCTION
FREQUENCY DIRECT FACTOR 23
EACH FOR M CONTENT DATA TO
BE REPRODUCED

END

FIG. 11

```
           ( START )
               │
               ▼
┌────────────────────────────────┐
│ RECEIVE REPRODUCTION           │ ─── S1101
│ FREQUENCY INFORMATION FROM     │
│ REPRODUCTION FREQUENCY         │
│ INFORMATION STORAGE UNIT 53    │
└────────────────────────────────┘
               │
               ▼
┌────────────────────────────────┐
│     CREATE RANDOM NUMBER       │ ─── S1102
│        TABLE 62                │
└────────────────────────────────┘
               │
               ▼
┌────────────────────────────────┐
│    RECEIVE RANDOM NUMBER       │ ─── S1103
│   FROM RANDOM GENERATOR 61     │
└────────────────────────────────┘
               │
               ▼
┌────────────────────────────────┐
│ REFERS TO RANDOM NUMBER        │ ─── S1104
│ TABLE 62 FOR COMPARISON        │
│ WITH RANDOM NUMBER, AND        │
│ SELECT CONTENT DATA FOR        │
│ REPRODUCTION                   │
└────────────────────────────────┘
               │
               ▼
           ( END )
```

# F I G . 1 2

**100**

| INDEX STORAGE REGION | 30 |
| REPRODUCTION CONTROL INFORMATION STORAGE REGION | 20 |
| CONTENT DATA STORAGE REGION | 10 |

RECORDING MEDIUM

DATA RECORDING AND REPRODUCTION DEVICE

**210**

REPRODUCTION ORDER DETERMINATION PART

**500**

REPRODUCTION CONTROL INFORMATION READ UNIT — 51

**54**

TIMER

REPRODUCTION ORDER INFORMATION GENERATION UNIT — 520

REPRODUCTION ORDER INFORMATION STORAGE UNIT — 530

REPRODUCTION CONTROL INFORMATION UPDATE PART — 80

**600**

CONTENT DATA SELECTION PART

**70**

REPRODUCTION PART

F I G . 1 3

START

S601
CAPABLE OF
SELECTING TRACKS FOR
REPRODUCTION ?

NO

YES

S602
SELECT M CONTENT DATA FOR
REPRODUCTION AMONG N ON
RECORDING MEDIUM

S603
SELECT EVERY DATA ON
RECORDING MEDIUM FOR
REPRODUCTION (M = N)

S604
RECEIVE REPRODUCTION
FREQUENCY INDIRECT FACTOR
22 EACH FOR M CONTENT DATA
TO BE REPRODUCED

S605
PROCESS REPRODUCTION
FREQUENCY INDIRECT FACTORS
22 FOR EASY COMPARISON,
AS T1 TO TM

S606
SORT AND NUMBER T1 TO TM

S607
ANY
SPECIFICATION
FOR THE NUMBER OF DATA
TO BE REPRODUCED
?

NO

YES

S608
IF THE SPECIFIED NUMBER OF
TRACKS IS L, EXTRACT FIRST
L SORTED INFORMATION

S609
REGARD CALCULATED VALUE AS
REPRODUCTION ORDER
INFORMATION

END

EP 1 107 255 A2

F I G .  1 4

1000

2000

USER'S SYSTEM

INFORMATION
PROVIDER'S SYSTEM

STEP S2

STEP S3

STEP S4

STEP S8

STEP S6

STEP S5

STEP S7

STEP S1

STEP S9

STEP S10

3000

CONTENT
MERCHANDISER'S
SYSTEM

FIG. 15

USER'S SYSTEM 1000

100

REPRODUCTION CONTROL INFORMATION MANAGEMENT PART 1002

COMMUNICATIONS PART 1001

INFORMATION PROVIDER'S SYSTEM 2000

COMMUNICATIONS PART 2001

USER'S INFORMATION MANAGEMENT PART 2002

2003

CONTENT MERCHANDISER'S SYSTEM 3000

COMMUNICATIONS PART 3001

BONUS OFFER PART 3004

CONTENT OFFER PART 3002

PASSWORD MANAGEMENT PART 3003

EP 1 107 255 A2